# FASCICULE DE BREVET EUROPEEN

(11) **EP 0 687 051 B1**
(45) Date de publication et mention de la délivrance du brevet: **04.08.1999**
(21) Numéro de dépôt: 95410041.8
(22) Date de dépôt: 04.05.1995
(51) Int. Cl.: H02H 9/02, H02H 9/04, H01L 27/02

(54) **Protection d'interface de lignes téléphoniques**
Telefonleitungs-Interface-Schutz
Telephone line interface protection

(30) Priorité: 09.05.1994 FR 9405925
(43) Date de publication de la demande: 13.12.1995
(73) Titulaire: STMicroelectronics S.A., 94250 Gentilly (FR)
(72) Inventeur: Bernier, Eric, F-37390 Mettray (FR)
(74) Mandataire: de Beaumont, Michel

(56) Documents cités:
- EP-A- 0 186 873
- WO-A-82/02287
- FR-A- 2 504 323
- FR-A- 2 566 582
- FR-A- 2 613 131
- GB-A- 2 186 763
- US-A- 4 849 846

## Description

La présente invention concerne la protection contre des surcharges électriques de centraux téléphoniques et plus particulièrement de l'interface entre une ligne téléphonique et ce central. Une telle interface est par exemple constituée d'une carte qui reçoit huit lignes téléphoniques et est couramment désignée dans la technique par l'appellation SLIC d'après les termes anglo-saxons Subscriber Line Interfaoe Circuit (circuit d'interface de ligne d'abonné).

Toutefois, bien que la présente invention soit décrite ci-après dans le cadre de cette application, on notera que l'invention prévoit également un circuit de protection contre des surtensions et des surintensités qui peut également s'appliquer à la protection d'un ou plusieurs conducteurs reliés à d'autres types de dispositifs électriques ou électroniques.

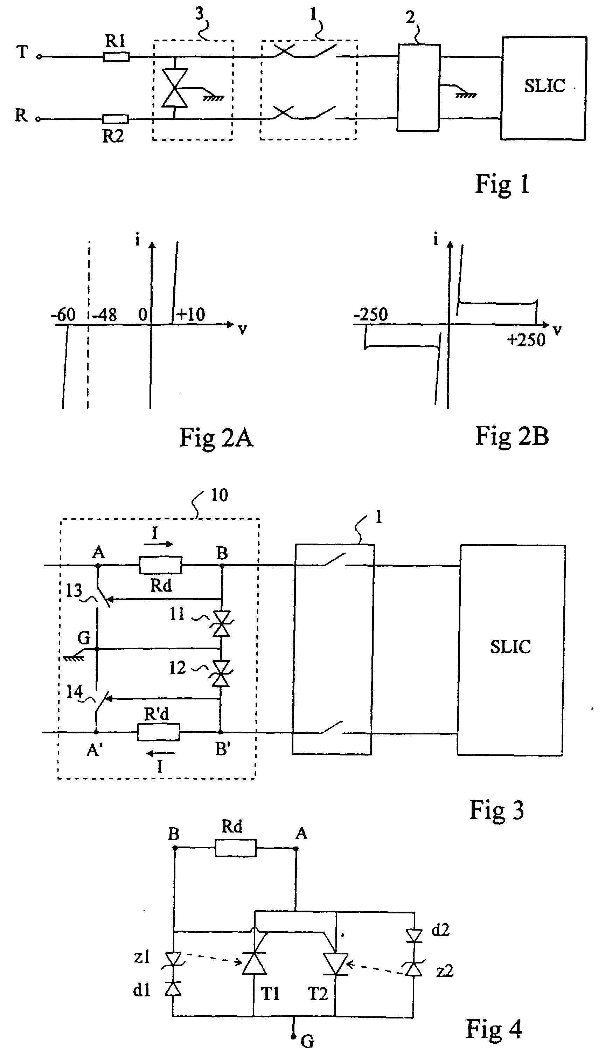

La figure 1 représente un mode de réalisation classique d'une interfaoe de ligne d'abonné (SLIC). Entre les conducteurs T et R (pointe et bague ou Tip et Ring) d'une ligne téléphonique d'abonné et l'interface SLIC, on trouve des résistances respectives R1 et R2 et un circuit 1 de relais de prise de ligne commandé par des bobines ou autres circuits de détection et de commande connectés d'une part à la ligne, d'autre part à l'interface.

Le mode de protection usuel consiste à placer un dispositif de protection 2 entre les relais 1 et l'interface SLIC. Ce dispositif de protection est prévu pour se déclencher, c'est-à-dire pour connecter l'un ou l'autre des conducteurs entre eux ou à la masse dès que la tension sur la ligne dépasse d'une valeur déterminée le niveau de tension normal sur la ligne, c'est-à-dire environ -48 volts pour le conducteur R et quelques volts négatifs pour le conducteur T. La protection se déclenche par exemple quand le potentiel sur le conducteur T est plus positif que 10 V et que le potentiel sur le conducteur R est plus négatif que -60 V, comme cela est représenté en figure 2A. Bien que la figure 2A représente une protection de type à écrêtage, on pourra aussi prévoir une protection du type à retournement, avec laquelle, quand la tension sort de la fourchette de -60 à +10 V, elle est ramenée à la valeur de -48 ou 0 V.

Les systèmes les plus anciens utilisaient cette seule protection 2 car l'ensemble à relais 1 était constitué de relais électromécaniques commandés par des bobines et, quand ces relais étaient ouverts, une surtension sur la ligne ne pouvait avoir aucun inconvénient. Or actuellement, on tend à remplacer les relais électromécaniques par des systèmes à semiconducteur dont les circuits de commande ne peuvent supporter des différences de potentiel trop importantes sur la ligne. On prévoit ainsi couramment des dispositifs de protection supplémentaires 3 qui se déclenchent quand la tension sur la ligne dépasse un seuil déterminé, par exemple une tension de ± 250 volts. Les dispositifs de protection 3 ont par exemple une courbe caractéristique telle que celle représentée en figure 2B (où ils sont du type à retournement). Bien entendu, quand les relais 1 sont fermés, le dispositif de protection 2 agira avant le dispositif de protection 3 qui n'est alors pas utilisé.

Cette conception d'une double protection d'une interface d'abonné présente deux inconvénients fondamentaux.

D'une part, et bien évidemment, le prix de la protection est élevé du seul fait qu'elle nécessite l'emploi d'au moins deux composants de protection qu'il faudra approvisionner et monter séparément.

D'autre part, si une surtension arrive tandis que les relais sont fermés, le dispositif de protection 2 entrera en action mais, pendant la durée de la surcharge, une surintensité importante peut traverser les relais 1 et cette surintensité peut être destructive quand les relais 1 sont du type à semiconducteur.

On connait par ailleurs de US- A- 4 849 846 un système de protection contre des surcharges d'une interface entre un central téléphonique et des relais reliés à une ligne d'abonné, comprenant un premier circuit de protection contre des surintensités disposé au-delà des relais de prise de ligne par rapport à l'interface et un second circuit de protection contre des surtensions disposé en deçà des relais de prise de ligne par rapport à l'interface.

On connait aussi de FR- A- 2 566 582 un composant monolithique de protection contre des surtensions, ce composant ayant une face supérieure et une face inférieure et comprenant une métallisation de face supérieure et une métallisation de face inférieure, des thyristors formés tête-bêche entre ces métallisations, un de ces thyristors étant amorcé en cas de surtension par une mise en avalanche d'une partie de la jonction entre une région centrale N commune aux deux thyristors et l'une ou l'autre des régions P adjacentes.

Ainsi, un premier but la présente invention est de prévoir un nouveau mode de protection d'une interface d'abonné qui pallie les inconvénients précédents et évite l'apparition de surintensités dans les relais en cas de surcharge tandis que ceux-ci sont à l'état fermé.

Pour atteindre ce but, la présente invention prévoit un système de protection contre des surcharges d'une interface entre un central téléphonique et des relais reliés à une ligne d'abonné, comprenant un circuit de protection unique disposé au-delà des relais de prise de ligne par rapport à l'interface, ce circuit de protection assurant une protection contre des surtensions, susceptible d'agir quand lesdits relais sont ouverts, et une protection contre des surintensités, susceptible d'agir quand les relais sont fermés.

Selon un mode de réalisation de la présente invention, ce système comprend un interrupteur commandé disposé entre chacun des conducteurs et la masse, qui est fermé par suite de la détection d'une surtension ou d'une surintensité.

Un autre but de la présente invention est de prévoir une réalisation sous forme de circuit monolithique d'un dispositif de protection unique réalisant une protection contre une surtension arrivant sur l'un des conducteurs d'une ligne ou une surintensité apparaissant dans cette ligne.

Un autre but de la présente invention est de prévoir un tel circuit monolithique qui soit particulièrement adapté à la protection d'une interface de ligne d'abonné.

Pour atteindre ces buts, il est prévu selon un deuxième aspect de la présente invention un composant monolithique de protection contre des surcharges électriques susceptibles de se produire sur un conducteur en série avec lequel est disposée une résistance de détection, ce composant ayant une face supérieure et une face inférieure et comprenant des première et deuxième métallisations de face supérieure destinées à être connectées aux bornes de ladite résistance, et une troisième métallisation de face inférieure destinée à être connectée à la masse ; des premier et deuxième thyristors formés tête-bêche entre les première et troisième métallisations, la deuxième métallisation correspondant à la gâchette de ces thyristors ; et une première diode à avalanche d'une première polarité entre les deuxième et troisième métallisations, et une deuxième diode à avalanche de polarité inverse entre l'une des première et deuxième métallisations et la troisième métallisation, ces première et deuxième diodes étant disposées pour que la mise en conduction de l'une d'entre elles provoque la mise en conduction de l'un des thyristors.

Selon un mode de réalisation de la présente invention, ce composant comprend un substrat du premier type de conductivité ; une première région du deuxième type de conductivité formée dans la surfaoe supérieure du substrat ; une deuxième région du deuxième type de conductivité formée dans la surface inférieure du substrat ; une troisième région du premier type de conductivité formée dans sensiblement la moitié de la surface de la première région ; une quatrième région du premier type de conductivité formée dans sensiblement la moitié de la surface de la deuxième région et sensiblement complémentaire de la troisième région ; une cinquième région du premier type de conductivité formée dans une portion de la première région au-dessus d'une portion de la quatrième région ; une sixième région du premier type de conductivité à fort niveau de dopage formée à l'interface entre la première région et le substrat ; une septième région du premier type de conductivité à fort niveau de dopage formée à l'interface entre la deuxième région et le substrat en regard d'au moins une partie de la quatrième région ; une première métallisation recouvrant la troisième région et la plus grande partie de la première région ; une deuxième métallisation recouvrant une portion de la première région au voisinage de la troisième région et la cinquième région ; et une troisième métallisation recouvrant les deuxième et quatrième régions.

Selon un mode de réalisation de la présente invention, la cinquième région a la forme d'une languette étroite.

Selon un mode de réalisation de la présente invention, les troisième et quatrième régions comportent des courts-circuits d'émetteurs et la densité de trous de court-circuit d'émetteur est plus élevée dans la troisième région que dans la quatrième.

Selon un mode de réalisation de la présente invention, le premier thyristor comprend une structure d'amplification de courant de gâchette.

Selon un mode de réalisation de la présente invention, le composant comprend une huitième région du deuxième type de conductivité formée dans la première région et contenant une neuvième région du premier type de conductivité, la deuxième métallisation recouvrant la huitième région et la cinquième région, une quatrième métallisation reliant la neuvième région à une portion de la première région voisine de la troisième région.

Selon un mode de réalisation de la présente invention, le composant comprend dans sa surface supérieure une région supplémentaire du deuxième type de conductivité destinée à être connectée à un circuit de détection de défaut, cette région supplémentaire étant polarisée à un potentiel plus élevé que celui de toutes les autres bornes du composant.

Selon un avantage de la présente invention, le composant monolithique comprend un seul élément de protection bidirectionnel principal connecté entre chacun des conducteurs de ligne et la masse. Cet élément principal est mis en conduction ou bien par l'apparition d'une surintensité sur la ligne ou bien par l'apparition d'une surtension sur au moins un conducteur de la ligne. Ainsi, dans ce composant monolithique, la surface peut être réduite puisqu'il ne comprend pas d'éléments distincts de protection contre les surintensités et contre les surtensions mais un seul élément de protection mis en oeuvre par des éléments de déclenchement sensibles à une surtension ou une surintensité, ces éléments de déclenchement n'étant pas amenés à laisser passer des courants importants et ne devant donc pas avoir une surface importante.

Ces buts, caractéristiques et avantages ainsi que d'autres de la présente invention seront exposés en détail dans la description suivante de modes de réalisation particuliers faite à titre non-limitatif en relation avec les figures jointes parmi lesquelles :
les figures 1, 2A et 2B destinées à illustrer un exemple du problème posé dans le cas particulier de la protection d'une interface de ligne téléphonique d'abonné ont été décrites précédemment ;
la figure 3 représente un schéma sous forme de blocs du concept de protection d'interface de ligne d'abonné selon la présente invention ;
la figure 4 illustre sous forme de circuit un mode de réalisation de la présente invention ;
les figures 5, 6 et 7 sont des vues en coupe schématiques illustrant divers modes de réalisation d'un dispositif selon la présente invention ; et
les figures 8A et 8B représentent respectivement une vue de dessus et une vue de dessous d'un mode de réalisation du composant de la figure 7.

La figure 3 illustre un système selon la présente invention et son mode de connexion pour une protection contre une surcharge d'une interface d'abonné et des relais de prise de ligne 1. Un dispositif de protection unique 10 assure d'une part une protection contre une surtension, active quand les relais 1 sont ouverts, représentée à titre d'exemple en figure 3 par des doubles diodes de Shockley 11 et 12, et d'autre part une protection contre des surintensités, active quand les relais 1 sont fermés. Ce dispositif de protection est connecté entre des bornes A et B disposées de part et d'autre d'une résistance de détection Rd en série avec le conducteur de pointe T de la ligne et des bornes A' et B' disposées de part et d'autre d'une résistance de détection R'd disposée en série avec le conducteur de bague R. Les surcharges éventuellement présentes sont évacuées vers une borne G reliée par exemple à la masse. Quand une surintensité est détectée, des commutateurs 13 et 14, disposés respectivement entre la borne A et la borne G et entre la borne A' et la borne G, sont fermés. Selon un aspect de ce dispositif qui sera développé ci-après, la mise en conduction de l'un ou l'autre des dispositifs de protection 11 et 12 entraine également immédiatement la fermeture de l'interrupteur 13 ou 14 correspondant. Ainsi, la présente invention diverge du mode de protection usuel consistant à disposer un dispositif de protection contre des surtensions aux bornes de l'interface SLIC elle-même et remplace ce dispositif de protection contre des surtensions par un dispositif de protection contre des surintensités ce qui présente l'avantage d'éviter toute apparition de surintensités dans les relais 1 quand ceux-ci sont à l'état fermé.

La figure 4 représente sous forme de circuit le schéma équivalent d'une moitié du dispositif de protection que vise à réaliser la présente invention. Cette figure représente seulement les éléments existant entre les bornes A, B et G, ce dispositif étant dupliqué entre les bornes A', B' et G. On trouve entre les bornes A et G deux thyristors tête-bêche T1 et T2 qui sont respectivement un thyristor à gâchette de cathode et un thyristor à gâchette d'anode. Ces gâchettes sont connectées à la borne B. Ainsi, quand un courant circule dans la résistance Rd, une différence de potentiel apparaît entre la gâchette et l'électrode principale correspondante et provoque la mise en conduction de l'un ou l'autre de ces thyristors selon le sens de circulation du courant. Le thyristor de polarité convenable entrera en conduction quand le potentiel sur sa gâchette différera du potentiel sur l'électrode principale correspondante d'une valeur de l'ordre de 0,7 V. On choisira donc la valeur R de la résistance en fonction de la valeur du courant I pour lequel on veut déclencher le système de protection pour que RI égale environ 0,7 V. Ainsi, pour des courants I de l'ordre de 100 à 200 mA, la résistance R aura une valeur de l'ordre de 6 à 3 ohms.

En outre, la présente invention prévoit de disposer des diodes à avalanche z1 et z2 entre la masse et l'une des bornes A ou B. Dans une réalisation pratique, comme on le verra ci-après, ces diodes à avalanche z1 et z2 se trouvent respectivement en série avec des diodes d1 et d2 de polarité opposée. Ainsi, par exemple, quand une surtension positive arrive sur les bornes A et B, la diode à avalanche z2 entrera en conduction et quand une surtension négative sera présente sur les bornes A et B, la diode à avalanche z1 entrera en conduction. Selon un aspect de la présente invention, ces diodes à avalanche sont conçues en relation avec les thyristors T1 et T2 pour que le déclenchement de la diode à avalanche z1 provoque la mise en conduction du thyristor T1 et que le déclenchement de la diode à avalanche z2 provoque la mise en conduction du thyristor T2. Ainsi, les diodes à avalanche z1 et z2 ne seront pas traversées par des courants importants puisque les surcharges seront évacuées par les thyristors T1 et T2. Les diodes à avalanche z1 et z2 pourront donc être de petite dimension.

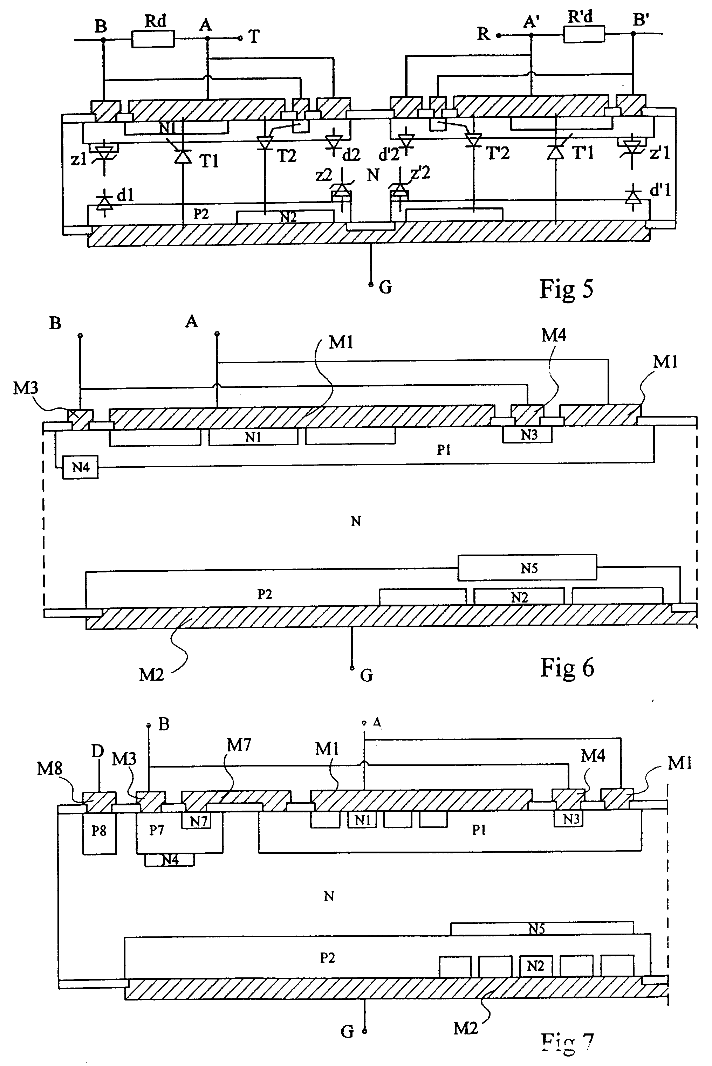

La figure 5 représente très schématiquement un mode de réalisation d'un composant selon la présente invention connecté entre les bornes A, B, A', B' et G. On a indiqué sur la figure 5 les positions approximatives des divers composants semiconducteurs équivalents permettant de faire la relation avec le circuit illustré en figure 4. La figure 6 représente une moitié agrandie de la figure 5. On se référera ci-après à l'ensemble des figures 5 et 6.

Comme le représente la figure 6, qui illustre la moitié gauche d'un composant selon la présente invention, un tel composant est formé à partir d'un substrat d'un premier type de conductivité qui sera ci-après considéré comme étant le type N. Dans les faces supérieure et inférieure de ce substrat sont formées des régions de type P respectives P1 et P2. Une région de type N, N1, est formée dans sensiblement la moitié de la surface de la région P1 et une région de type N, N2, est formée dans sensiblement la moitié de la surface de la région P2, de façon sensiblement complémentaire. De plus, une région de type N distincte, N3, est formée dans la région P1 en regard d'une portion de la région N2 formée dans la face opposée. Une région de type N à niveau de dopage élevé, N4, est formée à l'interface entre la région P1 et le substrat N sensiblement sous la région de contact de gâchette du thyristor T1 correspondant aux régions N1-P1-N-P2. Une région de type N à fort niveau de dopage, N5, est formée à l'interface entre la région P2 et le substrat N au-dessus d'une partie de la région N2. Une métallisation M1 recouvre la plus grande partie de la surface supérieure des régions N1 et P1. Une métallisation M2 recouvre la plus grande partie de la surface des régions P2 et N2 du côté de la face inférieure du composant. Une métallisation M3 recouvre une petite portion de la région P1, au voisinage de la région N1 et au-dessus de la région N4 susmentionnée. Une métallisation M4 recouvre la région N3. La métallisation M1 est reliée à la borne A, les métallisations M3 et M4 à la borne B et la métallisation M2 à la borne G.

En dehors des zones où elles reposent sur des régions semiconductrioes, les métallisations reposent sur des couches minces isolantes non-référencées (classiquement des couches minces d'oxyde de silicium).

Comme le représentent les figures 4 et 5, la partie du composant selon l'invention illustrée en figure 6 incorpore les composants suivants :
- un thyristor T1 constitué des couches P2-N-P1-N1 dont l'anode correspond à la métallisation M2, la cathode à la métallisation M1 et la gâchette à la métallisation M3 ;
- un thyristor T2 comprenant les couches P1-N-P2-N2 dont l'anode correspond à la métallisation M1 et la cathode à la métallisation M2, c'est-à-dire que ce thyristor T2 est en antiparallèle avec le thyristor T1 (ce thyristor T2 comprend en outre la région N3 qui constitue sa gâchette d'anode) ;
- une diode à avalanche z1 correspondant à la jonction P1-N4, dont l'anode correspond à la métallisation M3 et la cathode à la métallisation M2 (cette diode à avalanche z1 est en série avec une diode d1 correspondant à la jonction N-P2) ; et
- une diode à avalanche z2 correspondant à la jonction P2-N5, dont l'anode correspond à la métallisation M2 et la cathode à la métallisation M1 (cette diode à avalanche est en série avec une diode d2 correspondant à la jonction P1-N).

La structure des figures 5 et 6 correspond donc bien au schéma équivalent illustré en figure 4. Dans la partie droite de la figure 5 apparaissent des composants élémentaires T'1, T'2, z'1, z'2, d'2 symétriques des composants décrits ci-dessus et connectés aux bornes A' B' et G.

Le fonctionnement du dispositif est le suivant.

Quand les relais 1 sont ouverts et qu'une surtension négative par rapport à la masse survient sur les bornes A et B, la diode à avalanche z1 entre en avalanche et des porteurs sont générés au voisinage de la jonction P1-N. En conséquence, le thyristor T1 devient passant et la surtension est évacuée vers la masse par ce thyristor T1.

Quand les relais 1 sont ouverts et qu'une surtension positive par rapport à la masse survient sur les bornes A et B, la diode à avalanche z2 entre en avalanche. Cette mise en avalanche crée une génération de porteurs au voisinage de la jonction N-P2 du thyristor T2 et ce thyristor entre à son tour en conduction.

Quand les relais 1 sont fermés et qu'une surintensité négative survient sur la ligne, une tension positive apparaît entre la borne B et la borne A. Quand cette tension atteint environ 0,7 V, un courant de gâchette peut circuler dans la jonction P1-N1 et le thyristor à gâchette de cathode T1 s'amorce de façon classique.

Quand les relais 1 sont fermés et qu'une surintensité positive survient sur la ligne, un courant positif circule de la borne A à la borne B et un potentiel positif apparaît entre ces bornes. Ainsi, la jonction P1-N3 est polarisée en direct et, dès que l'on atteint la tension de seuil de conduction en direct de la diode P1-N3 (environ 0,7 V), une circulation de courant dans la jonction P1-N3 provoque la génération de porteurs également au voisinage de la jonction P1-N et ceci provoque l'amorçage du thyristor T2 (P1-N-P2-N2).

On a exposé ci-dessus le fonctionnement général d'un composant selon la présente invention. Il faut en outre qu'il satisfasse à diverses caractéristiques de sensibilité et de symétrie pour remplir convenablement la fonction qu'il doit assumer.

L'amorçage du thyristor T1 ou T2 par la diode à avalanche z1 ou z2 ne pose pas de problème particulier. Il suffira de choisir le niveau de dopage des régions N4 et N5 pour obtenir une tension d'avalanche souhaitée, par exemple 250 volts. De plus, en cas de surcharge tandis que les relais sont ouverts, en fin de surcharge, aucune tension n'est présente sur la ligne et celui des thyristors T1 ou T2 qui est entré en conduction se désamoroe naturellement.

Le problème est plus compliqué en cas d'amorçage par une surintensité. En effet, le dispositif doit satisfaire à trois contraintes.

La première contrainte est que les thyristors doivent s'amorcer pour le passage d'un courant déterminé dans la résistance R, par exemple un courant de l'ordre de 200 milliampères. Pour atteindre ce résultat, il faut que le courant de gâchette susceptible de mettre en conduction les thyristors soit faible devant le courant dans la résistance Rd, par exemple de l'ordre de 20 milliampères. Il en résulte que les thyristors T1 et T2 doivent être relativement sensibles.

La deuxième contrainte est que le dispositif doit être aussi symétrique que possible, c'est-à-dire s'amorcer pour sensiblement les mêmes seuils de surintensité positive et négative.

La troisième contrainte se présente en particulier dans le cas où le dispositif est destiné à protéger une ligne téléphonique. Alors, quand les relais sont fermés, il apparaît en permanence une tension de l'ordre de -48 V sur la borne de bague (R) par rapport à la borne G. Il faut donc que le thyristor (T1 ou T'1) dont l'anode correspond à la borne G et la cathode à la borne de bague puisse se rebloquer quand une tension de 48 V est présente entre ces bornes. Ceci ne pose pas de problème critique pour le thyristor T1 ou T'1 car la résistance Rd se trouve en série avec le thyristor et la contrainte sur le courant de maintien du thyristor est en pratique raisonnable. Par contre, en examinant la figure 6, on voit qu'il existe en outre un thyristor parasite P2-N-P1-N3 dont l'anode correspond à la borne G et la cathode à la borne B. Cette borne B est directement reliée à la tension de -48 V. Il faudra donc que ce thyristor parasite présente un courant de maintien élevé pour ne pas rester conducteur à la fin d'une surcharge.

On montrera ci-après que l'on peut satisfaire à ces trois contraintes par un choix approprié des surfaces des diverses couches, des dispositions des régions de gâchette, et des densités des trous de court-circuit d'émetteur formés à travers les régions N1 et N2.

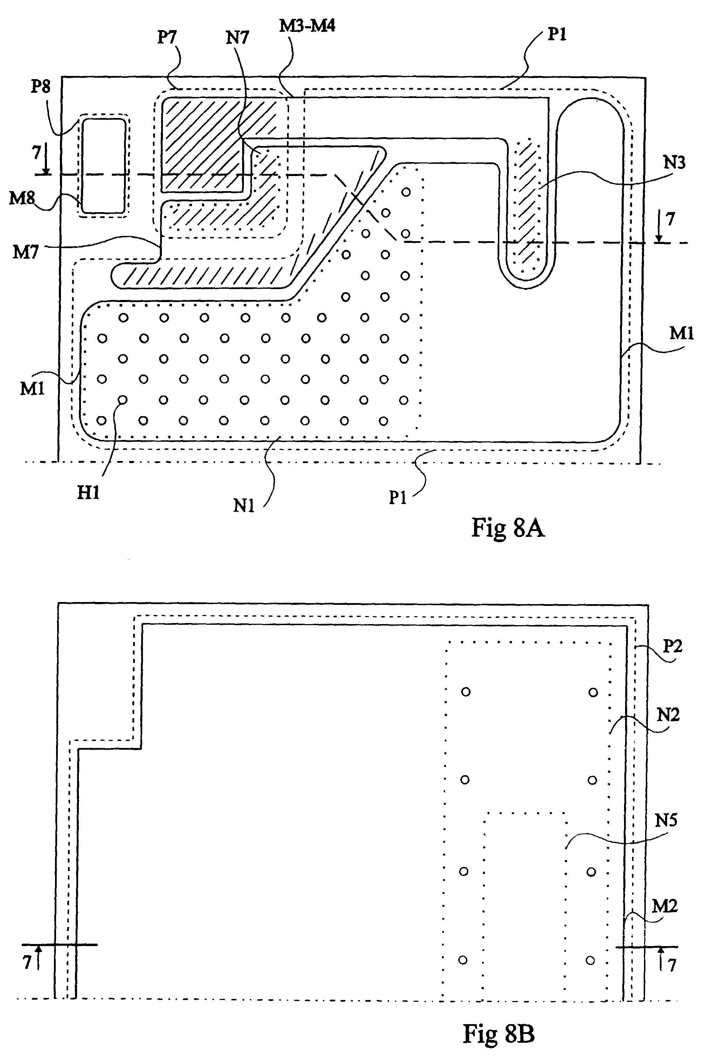

La figure 7 représente une vue en coupe d'une variante d'un demi-composant selon la présente invention dans laquelle on a adjoint au dispositif de la figure 6 une structure à amplification de courant de gâchette pour le thyristor T1 et une structure d'indication de défaut.

La partie droite de la figure 7 est identique à la figure 6 et de mêmes couches et régions y sont désignées par de mêmes références.

Une région de type P, P7, est formée à partir de la face supérieure du substrat N au voisinage de la région de gâchette du thyristor T1. Dans la région P7 est formée une région de type N, N7. La région N4 au lieu d'être formée sous une portion de la région P1 est formée sous la région P7. La métallisation M3, au lieu d'être disposée sur une portion de la région P1 est disposée sur une surface apparente de la région P7 et une métallisation M7 relie une partie de la surface supérieure de la région N7 à une partie de la surface supérieure de la région P1. La métallisation M7 n'est pas reliée à une borne extérieure. La métallisation M3 est reliée à la borne B. On a ainsi formé de façon classique un thyristor T1 à amplification de gâchette dont la sensibilité est augmentée. La diode à avalanche z1 correspond maintenant à la jonction P7-N4 et, comme auparavant, sa mise en conduction déclenchera la mise en conduction du thyristor T1.

En outre, la présente invention prévoit d'associer au composant décrit précédemment un détecteur de défaut. Pour cela, une région supplémentaire P8 est formée dans la surface supérieure du substrat 1 et est solidaire d'une métallisation M8 reliée à une borne D. Cette borne D est reliée à un indicateur de défaut et à une source de tension plus positive que celle de chacune des bornes A, B et G. Ainsi, en fonctionnement normal, il existe entre la borne D et chacune des bornes A, B et G une jonction bloquante (les jonctions N-P1, N-P7 et N-P2). Par contre, si par suite d'une surcharge trop intense, le composant selon la présente invention entre en court-circuit, l'une des jonctions N-P1, N-P7 ou N-P2 sera détruite et correspondra à un court-circuit. Alors, un courant sera susceptible de passer entre la borne D et l'une des bornes A, B et G. Ce courant sera détecté par le détecteur de défaut. Ce détecteur de défaut peut être associé à un système de visualisation ou d'alarme proche ou distant du composant.

Les figures 8A et 8B représentent respectivement une vue de dessus et une vue de dessous retournée du composant illustré en figure 7 qui en est une vue en coupe selon les lignes 7-7 marquées en figures 8A et 8B. Dans ces figures, les contours des métallisations sont désignés par des traits continus, les contours des régions P par des tirets, et les contours des régions N par des suites de points.

On reconnaît ainsi en figure 8A les métallisations M1, M3-M4 (une seule métallisation), M7 et M8, les régions de type P, P1, P7 et P8, et les régions de type N, N1, N3 et N7. La région N4 non représentée s'étend sensiblement sous la région P7. Sous la métallisation M7, on a représenté par des hachures les zones de contact avec la région N7 et avec une portion servant de gâchette de la région P1. Le reste de la métallisation N7 est formé sur un isolant (un oxyde). De même, pour la métallisation M3-M4, on a représenté par des hachures son contact avec la région N3 et avec la portion de la région P7 où n'est pas formée la région N7. Cette figure 8A ne constitue qu'un exemple de réalisation d'une structure selon la présente invention. On en notera toutefois les caractéristiques suivantes :
- la région P1 occupe la plus grande partie de la surface du composant ;
- la région N1 occupe sensiblement la moitié de la surface de la région P1 ;
- la densité de trous de court-circuit d'émetteur H1 formés dans la région N1 est relativement élevée pour que le thyristor T1 présente un courant de maintien relativement élevé, l'obtention d'une sensibilité élevée pour ce thyristor étant obtenue grâce à la structure d'amplification de courant de gâchette ;
- la région N3 est constituée d'une bande allongée et étroite pour que le thyristor parasite P2-N-P1-N3 présente un courant de maintien élevé. Cette bande N3 a par exemple une largeur de l'ordre de 120 micromètres ;
- la région N7 constituant l'émetteur du thyristor pilote est exempte de trous de court-circuit pour obtenir une forte sensibilité.

Dans la vue de dessous de la figure 8B, on reconnaît la métallisation M2, la région de type P, P2, la région de type N, N2, et la région de type N, N5, formée à l'interface des régions P2 et N. Dans cette figure, on notera que :
- la région P2 ne s'étend pas sous la région P8 (ceci n'est toutefois pas nécessaire) ;
- la région N2 comporte une très faible densité de trous de court-circuit d'émetteur. Ceci est destiné à obtenir une sensibilité relativement élevée pour le thyristor à gâchette d'anode T2. Bien entendu, la conséquence en est que ce thyristor aura un courant de maintien faible mais cela n'est pas gênant puisque, comme on l'a indiqué précédemment, à la fin d'une surcharge, ce thyristor voit une tension sensiblement nulle à ses bornes.

Bien entendu, la présente invention est susceptible de nombreuses variantes et modifications qui apparaîtront à l'homme de l'art notamment en ce qui concerne les types de topologie des diverses couches illustrées à titre d'exemple seulement en figures 8A et 8B.

Bien que les types de conductivité de toutes les couches puissent être intervertis, on préfèrera la structure illustrée dans laquelle le substrat est de type N pour permettre d'assurer convenablement le compromis entre sensibilité et courant de maintien décrit précédemment.

De plus, bien que l'on ait appelé "masse" dans la présente description la borne à potentiel fixe vers laquelle sont évacuées les surcharges, on notera que cette "masse" peut être autre que la masse du circuit à protéger et que le potentiel de référence de la ligne.

## Revendications

1. Système de protection contre des surcharges d'une interface entre un central téléphonique et des relais (1) reliés à une ligne d'abonné, comprenant un circuit de protection unique (10) disposé au-delà des relais (1) de prise de ligne par rapport à l'interface, caractérisé en ce que ce circuit de protection (10) assure une protection contre des surtensions, susceptible d'agir quand lesdits relais sont ouverts, et une protection contre des surintensités, susceptible d'agir quand les relais sont fermés.

2. Système selon la revendication 1, comprenant un interrupteur commandé (13, 14) disposé entre chacun des conducteurs et la masse, qui est fermé par suite de la détection d'une surtension ou d'une surintensité.

3. Composant monolithique de protection contre des surcharges électriques susceptibles de se produire sur un conducteur en série avec lequel est disposée une résistance de détection (Rd), ce composant ayant une face supérieure et une face inférieure et comprenant :
des première et deuxième métallisations de face supérieure (M1, M3-M14) destinées à être connectées aux bornes (A, B) de ladite résistance (Rd), et une troisième métallisation de face inférieure (M2) destinée à être connectée à la masse ;
des premier et deuxième thyristors (T1, T2) formés tête-bêche entre les première et troisième métallisations, la deuxième métallisation correspondant à la gâchette de ces thyristors ; et
une première diode à avalanche (zl) d'une première polarité entre les deuxième et troisième métallisations, et une deuxième diode à avalanche (z2) de polarité inverse entre l'une des première et deuxième métallisations et la troisième métallisation, ces première et deuxième diodes étant disposées pour que la mise en conduction de l'une d'entre elles provoque la mise en conduction de l'un des thyristors.

4. Composant de protection selon la revendication 3, comprenant :
un substrat du premier type de conductivité (N) ;
une première région du deuxième type de conductivité (P1) formée dans la surface supérieure du substrat ;
une deuxième région du deuxième type de conductivité (P2) formée dans la surface inférieure du substrat ;
une troisième région du premier type de conductivité (N1) formée dans sensiblement la moitié de la surface de la première région (P1) ;
une quatrième région du premier type de conductivité (N2) formée dans sensiblement la moitié de la surface de la deuxième région (P2) et sensiblement complémentaire de la troisième région (N1) ;
une cinquième région du premier type de conductivité (N3) formée dans une portion de la première région (P1) au-dessus d'une portion de la quatrième région ;
une sixième région du premier type de conductivité à fort niveau de dopage (N4) formée à l'interface entre la première région (P1) et le substrat ;
une septième région du premier type de conductivité à fort niveau de dopage (N5) formée à l'interface entre la deuxième région (P2) et le substrat (N) en regard d'au moins une partie de la quatrième région (N2) ;
une première métallisation (M1) recouvrant la troisième région (N1) et la plus grande partie de la première région (P1) ;
une deuxième métallisation (M3, M4) recouvrant une portion de la première région (P1) au voisinage de la troisième région et la cinquième région (N3) ; et
une troisième métallisation recouvrant les deuxième (P2) et quatrième (N2) régions.

5. Composant de protection selon la revendication 4, caractérisé en ce que la cinquième région (N3) a la forme d'une languette étroite.

6. Composant de protection selon la revendication 4, caractérisé en ce que les troisième et quatrième régions (N1, N2) comportent des courts-circuits d'émetteurs et en ce que la densité de trous de court-circuit d'émetteur est plus élevée dans la troisième région que dans la quatrième.

7. Composant de protection selon la revendication 3, caractérisé en ce que le premier thyristor comprend une structure d'amplification de courant de gâchette (P7, N7).

8. Composant de protection selon les revendications 3, 4 et 7, caractérisé en ce qu'il comprend une huitième région du deuxième type de oonductivité (P7) formée dans la première région et contenant une neuvième région du premier type de conductivité (N7), la deuxième métallisation (M3, M4) recouvrant la huitième région (P7) et la cinquième région (N3), une quatrième métallisation reliant la neuvième région (N7) à une portion de la première région (P1) voisine de la troisième région (N1).

9. Composant de protection selon la revendication 4, caractérisé en ce qu'il comprend dans sa surface supérieure une région supplémentaire du deuxième type de conductivité (P8) destinée à être connectée à un circuit de détection de défaut, cette région supplémentaire étant polarisée à un potentiel plus élevé que celui de toutes les autres bornes du composant.

## Claims

1. A protection system against overloads that may occur on an interface between a telephone exchange and line switches (1) connected to a subscriber's line, comprising a single protection circuit (10) disposed beyond the line switches with respect to the interface, characterized in that said overvoltage protection system (10) ensures an overvoltage protection operative when the line switches are off, and an overcurrent protection operative when the line switches are on.

2. The system of claim 1, comprising a controlled switch (13, 14) disposed between each conductor and ground, that is closed in response to the detection of an overvoltage or overcurrent.

3. A monolithic protection component against electrical overloads that may occur on a conductor with which a detection resistor (Rd) is disposed in series, said component having an upper surface and a lower surface, and including:
first and second upper metallizations (M1, M3-M14) intended to be connected to the terminals (A, B) of said resistor (Rd), and a third lower metallization (M2) intended to be connected to ground;
first and second thyristors (T1, T2) head-to-tail connected between the first and third metallizations, the second metallization corresponding to the gate of said thyristors; and
a first avalanche diode (z1) of a first polarity between the first and third metallizations, and a second avalanche diode (z2) of a reverse polarity between one of the first and second metallizations and the third metallization, said first and second diodes being disposed so that the conduction of one of the diodes causes the switching-on of one of the thyristors.

4. The protection component of claim 3, including:
a substrate (N) of a first conductivity type ;
a first region (P1) of a second conductivity type formed in the upper surface of the substrate;
a second region (P2) of the second conductivity type formed in the lower surface of the substrate;
a third region (N1) of the first conductivity type formed in substantially one half of the surface area of the first region (P1);
a fourth region (N2) of the first conductivity type formed in substantially one half of the surface area of the second region (P2) and substantially complementing the third region (N1);
a fifth region (N3) of the first conductivity type formed in a portion of the first region (P1) over a portion of the fourth region;
a sixth high doped region of the first conductivity type (N4) formed at the interface of the first region (P1) with the substrate;
a seventh high doped region of the first conductivity type (N5) formed at the interface of the second region (P2) with the substrate (N) facing at least a portion of the fourth region (N2);
a first metallization (M1) coating the third region (N1) and most of the first region (P1);
a second metallization ( M3, M4) coating the fifth region (N3) and a portion of the first region (P1) near the third region; and
a third metallization coating the second (P2) and fourth regions ( N2 ).

5. The protection circuit of claim 4, characterized in that the fifth region (N3) is a narrow strip.

6. The protection component of claim 4, characterized in that the third and fourth regions (N1, N2) include emitter shorts and wherein the density of the emitter shorting holes is higher in the third region than in the fourth region.

7. The protection component of claim 3, characterized in that the first thyristor includes a gate current amplifying structure ( P7, N7 ).

8. The protection component of claims 3, 4 and 7, characterized in that it includes an eighth region (P7) of the second conductivity type formed in the first region, and including a ninth region (N7) of the first conductivity type, the second metallization (M3, M4) coating the eighth (P7) and fifth (N3) regions, a fourth metallization connecting the ninth region ( N7) to a portion of the first region (P1) adjacent to the third region (N1).

9. The protection component of claim 4, characterized in that it includes in its upper surface an additional region (P8) of the second conductivity type intended to be connected to a failure detection circuit, said additional region being biased at a voltage higher than the voltage of all the other terminals of the component.

## Patentansprüche

1. Überlastschutz-System für ein Interface zwischen einer Telephonzentrale und mit einer Teilnehmerleitung verbundenen Relais (1), welches eine einzige Schutzschaltung (10) aufweist, die relativ bezüglich dem Interface jenseits der Leitungsbelegungsrelais angeordnet ist,
**dadurch gekennzeichnet**, daß
diese Schutzschaltung (10) einen im Öffnungs- bzw. Ausschaltzustand der genannten Relais wirksamen Schutz gegen Überspannungen und einen im geschlossenen bzw. eingeschalteten Zustand der Relais wirksamen Schutz gegen Überströme gewährleistet.

2. System nach Anspruch 1, welches einen gesteuerten Schalter (13,14) in Anordnung zwischen jeweils jedem der Leiter und Masse aufweist, der nach einer Detektion einer Überspannung oder eines Überstroms geschlossen wird.

3. Monolithisches Bauteil als Schutz gegen elektrische Überlastungen, die auf einem Leiter auftreten können, mit welchem in Reihe ein Detektionswiderstand (Rd) angeordnet ist, wobei dieses Bauteil eine Ober- und eine Unterseite besitzt und umfaßt:
erste und zweite Metallisierungen (M1, M3 - M14) auf der Oberseite, zur Verbindung mit Anschlüssen (A, B) des genannten Wderstands (Rd), sowie eine dritte Metallisierung (M2) auf der Unterseite, zur Verbindung mit Masse;
erste und zweite Thyristoren (T1, T2) in antiparalleler Ausbildung zwischen den ersten und dritten Metallisierungen, wobei die zweite Metallisierung dem Gate dieser Thyristoren entspricht; sowie
eine erste Lawinen- bzw. Z-Diode (z1) in einer ersten Polung zwischen den zweiten und dritten Metallisierungen, und eine zweite Lawinen- bzw. Z-Diode (z2) in umgekehrter Polung zwischen einer von der ersten oder zweiten Metallisierung und der dritten Metallisierung, wobei diese erste und zweite Diode so vorgesehen sind, daß der Übergang einer von ihnen in den leitenden Zustand das Leitendwerden eines der Thyristoren bewirkt.

4. Schutzbauteil nach Anspruch 3, welches umfaßt:
ein Substrat (N) vom ersten Leitfähigkeitstyp;
einen in der Oberseite des Substrats ausgebildeten ersten Bereich (P1) vom zweiten Leitfähigkeitstyp;
einen in der Unterseite des Substrats ausgebildeten zweiten Bereich (P2) vom zweiten Leitfähigkeitstyp;
einen im wesentlichen in der halben Fläche des ersten Bereichs (P1) ausgebildeten dritten Bereich (N1) vom ersten Leitfähigkeitstyp;
einen im wesentlichen in der halben Fläche des zweiten Bereichs (P2) ausgebildeten und zum dritten Bereich im wesentlichen komplementären vierten Bereich (N2) vom ersten Leitfähigkeitstyp;
einen in einem Teil des ersten Bereichs (P1) über einem Teil des vierten Bereichs ausgebildeten fünften Bereich (N3) vom ersten Leitfähigkeitstyp;
einen in der Grenzfläche zwischen dem ersten Bereich (P1) und dem Substrat ausgebildeten sechsten Bereich (N4) hoher Dotierung vom ersten Leitfähigkeitstyp;
einen in der Grenzfläche zwischen dem zweiten Bereich (P2) und dem Substrat (N) gegenüber wenigstens einem Teil des vierten Bereichs (N2) ausgebildeten siebenten Bereich (N5) hoher Dotierung vom ersten Leitfähigkeitstyp;
eine den dritten Bereich (N1) und den größten Teil des ersten Bereichs (P1) überdeckende erste Metallisierung;
eine einen Teil des ersten Bereichs (P1) benachbart dem dritten Bereich und den fünften Bereich (N3) überdeckende zweite Metallisierung (M3, M4); sowie
eine den zweiten Bereich (P2) und den vierten Bereich (N2) überdeckende dritte Metallisierung.

5. Schutzbauteil nach Anspruch 4, dadurch gekennzeichnet, daß der fünfte Bereich (N3) die Form einer schmalen Zunge hat.

6. Schutzbauteil nach Anspruch 4, dadurch gekennzeichnet, daß die dritten und die vierten Bereiche (N1, N2) Emitter-Kurzschlüsse aufweisen, und daß die Dichte der Emitterkurzschlußlöcher bzw. -öffnungen im dritten Bereich größer als im vierten Bereich ist.

7. Schutzbauteil nach Anspruch 3, dadurch gekennzeichnet, daß der erste Thyristor eine Gate-Stromverstärker-Struktur (P7, N7) umfaßt.

8. Schutzbauteil nach den Ansprüchen 3, 4 und 7, dadurch gekennzeichnet, daß es einen in dem ersten Bereich ausgebildeten achten Bereich (P7) vom zweiten Leitfähigkeitstyp umfaßt, der einen neunten Bereich (N7) vom ersten Leitfähigkeitstyp enthält, daß die zweite Metallisierung (M3,M4) den achten Bereich (P7) und den fünften Bereich (N3) überdeckt, und daß eine vierte Metallisierung den neunten Bereich (N7) mit einem Teil des ersten Bereichs (P1) benachbart dem dritten Bereich (N1) verbindet.

9. Schutzbauteil nach Anspruch 4, dadurch gekennzeichnet, daß es in seiner Oberseite einen zusätzlichen Bereich (P8) vom zweiten Leitfähigkeitstyp zum Zweck der Verbindung mit einer Störzustand-Detektionsschaltung aufweist, wobei dieser zusätzliche Bereich auf ein höheres Potential als sämtliche anderen Anschlüsse des Bauteils vorgespannt ist.
